# EUROPEAN PATENT SPECIFICATION

(11) **EP 2 909 642 B1**
(45) Date of publication and mention of the grant of the patent: **30.11.2016**
(21) Application number: 13779735.3
(22) Date of filing: 17.10.2013
(51) Int. Cl.: G01R 15/18, H01F 27/06

(54) **FASTENING MEANS FOR CURRENT AND/OR VOLTAGE SENSOR**
BEFESTIGUNGSEINRICHTUNG FÜR STROM- UND/ODER SPANNUNGSSENSOR
SUPPORT DE FIXATION POUR CAPTEUR DE COURANT ET/OU DE TENSION

(30) Priority: 18.10.2012 EP 12007204
(43) Date of publication of application: 26.08.2015
(73) Proprietor: ABB Schweiz AG, 5400 Baden (CH)
(72) Inventor: VELESIK, Petr, 602 00 Brno (CZ); PODZEMNY, Jaromir, 621 00 Brno (CZ); RASCHKA, David, 664 91 Ivancice (CZ)
(74) Representative: Schmidt, Karl Michael
(86) International application number: PCT/EP2013/003125
(87) International publication number: WO 2014/060104

(56) References cited:
- WO-A1-2011/073397
- WO-A1-2011/073434
- WO-A1-2011/083030
- CN-A- 101 286 412
- JP-A- 2003 072 484
- US-A1- 2008 079 437
- US-A1- 2008 284 410
- US-A1- 2010 155 136

## Description

The invention relates to fasting means for current and/or voltage sensor in low- medium and high voltage use according to the preamble of claim 1.

A required position of a ring-core type low-, medium- or high- current and/or voltage sensing device is achieved by the sensing device design and its dimensions and by construction of an electrical device containing a source, i. e. a sensing device primary conductor, of a current and/or voltage signal to be measured. For fastening of the sensing device to the electrical device containing the primary conductor there is used either tightening strap or another supplementary fastening material such the bolts, an adhesive, etc. It introduces necessity of the additional fastening material and special assembling tools application what negatively influences the manufacturing time and production costs. Next disadvantage of the solution described above, especially in using tightening straps, is impossibility of the requested perpendicularity to the primary conductor and centering of the sensing device around the primary conductor ensurance what can lead to decreased measurement device sensing accuracy.

In the WO 2011/083030 A1 a device for detatchably fastening a current conductor to a current transformer housing is disclosed. This fastening device is embellished for a special current transformer housing geometry.

So it is an object of the invention to enhance fasting means or device for fasting current and/or voltage sensors in such a way, that the fixation is accurate and reproductive as well.

So based on this, the invention is, that the fastening device comprise a number of at least two fastening elements, each with a dowel pin clip, or a clamp at a first section of the fastening element, and a support element at a second section of the fastening element, so that the dowel pin clip or the clamp has to be inserted into, or clamped on the sensors housing at the first section, and the support element at the second section has to be fixed on the electrical conductor.

In an advantageous embodiment the support element of an arrangement of the at least two fastening elements are fixed on the electrical conductor commonly with a tightening strap or a fixating ring. This ensures an accurate and stabilized position of a voltage and/or current measurement device within the measured voltage and/or current signal source which has possitive effect to the voltage and/or current measurement device sensing accuracy. By the use of two fastening elements a good centered position of the sensor is given. But better are at least three fastening element.

In a further embodiment, the support element is provided with an eye-element, through which the tightening strap or fixation ring is guided, in order to fixe the position of the fastening element.

So in a very advantageous embodiment, the sensor geometry is a circular ring element, to be positioned round an electrical conductor.

In a further advantageous embodiment, the fixating ring or the tightening strap is removable, and or changeable in the position.

For fixation of this inventive fastening element there is no need to use an assembling tool and/or additional fastening material, they provide an option to apply a tightening strap, conducted through a specially designed segment, like an eye, of the mechanical fastening element and/or placed on the mechanical fastening element surface to obtain greater contact force if needed.

In a further embodiment the first section and the second section of the fastening element are connected together in a fixed angle position between 90° and 180°. Mostly advantageous is an angle defined by 90°.

An alternative embodiment is given by that the first section and the second section of the fastening element are connected in that way, that the angle position between the first and the second section is variable/adjustable between 90° and 180°.
This embodiment has its advantage in the in applications to electrical conductors with small diameters. As well, by this embodiment, the fastening element can be applied on several different conductor diameters.

A last advantageous embodiment describes, that the first section is pivotable relative to the second section in that way, that the pivotation plane is rectangular to the long axis of the conductor. This gives a simple but effective possibility to adapt the fastening elements to lower conductor diameter.

An advantageous embodiment comprises the feature, that the contact side of the second section of the fastening element to the conductor surface is provided with a rough or structured surface or with such a surface coverage.
By this, a very good contact an sure positioning is given.

A further very advantageous embodiment of the invention is, that at least two fastening elements are fixed with their dowel pin or dowel pin clip in openings placed at the circumferential region of a toroidal current sensor and/or voltage sensor housing, and that the axis of the openings are in parallel to the conductor.

Furthermore advantageous is, that the toroidal housing is placed around a conductor in such, that the fastening elements can be rotated aroung the dowel pin axis in such, that the second section (3") can be placed and adapted towards the conductors shell or skin surface, in order to adapt to different conductor diameters.
By that the toroidal housing can be placed around the conductor, AND the fixation of the sensor device is independent from the conductor diameter. It can be fitted easily to different conductor diameter.

The invention is dealing with an improvement of a current and/or voltage sensing means or device positioning system and with increasing measurement device sensing accuracy as a result of the stable and fixed measurement device placement within a complete electrical system. It claims implementation of the unique fastening elements designed to ensure fast and easy instalation and stabilization of the current and/or voltage sensing device in a proper position with no assembling tool usage and, thus, to reduce amplitude error and phase displacement, as well as to reduce manufacturing time and production costs.

The inventions is shown in
Figure 1: side, front and detailed view of the fastening element with rectangular position of first to second section,
Figure 2: side, front and detailed view of the fastening element with angular position between 90 and 180°of first to second section,
Figure 3: side, front and detailed view of the fastening element with a pivotable first section
Figure 4: shows a perspective view to the placement of a voltage and/or current sensor device on a conductor.
Figur 5: shows in detail how the fixation elements fit or shrink to the conductors surface dimension.

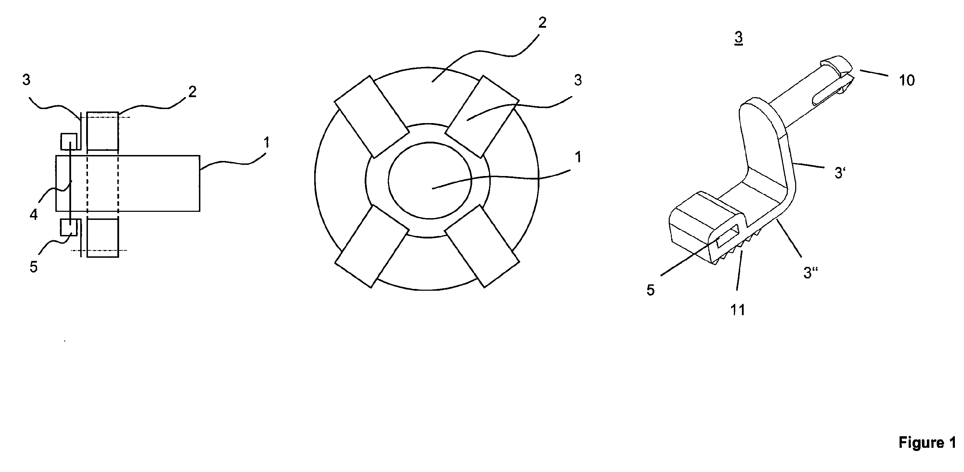

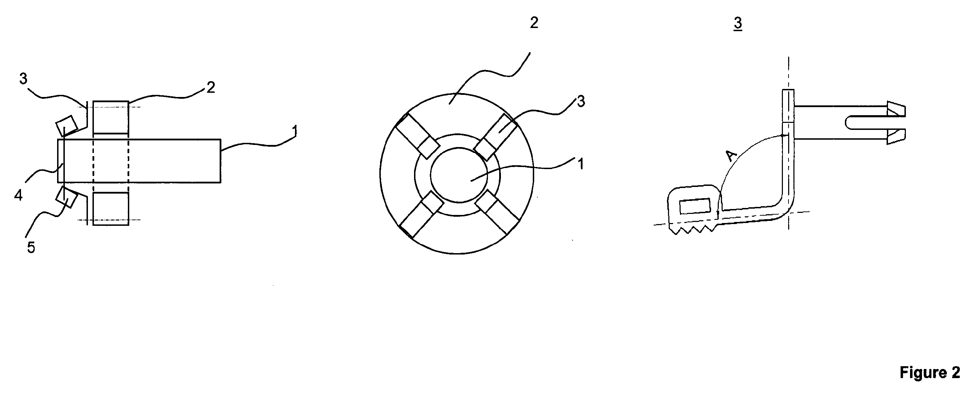

According to all embodiments this invention describes the application of the special construction fastening elements 3 ensuring the simple sensing device 2 fixation in the most appropriate position on the primary conductor 1 and, therefore a stable current and/or voltage signals measurement with high accuracy, like shown in figure 1. In case the greater contact force value between the fastening elements 3 and neither directly the primary conductor 1 or the electrical device containing the primary conductor 1 is needed the fastening element 3 design, which allows a possibility of using a tightening strap 4 conducted through a hole or eye-element 5 and/or placed on the fastening element 3 surface, like shown in figure 1 and figure 2.
In figure 1, the first section 3' is provided with a dowel pin 10, which has to be inserted into a hole in the housing of the sensor 2. The first section 3' is oriented in an angle of 90° to the second section 3". The second section 3" has to be brought into close contact to the surface of the conductor 1. For a good positioning, the contact side of the second section is provided with a structured surface area 11 or a such structured coverage.

Figure 2 shows the special design of the fastening element 3 that could be an option for the applications, where the primary conductor diameter is significantly smaller in comparison to the measurement of device 2 inners diameter. The proper contact force value between the fastening elements 3 and neither directly the primary conductor 1 or the electrical device containing the primary conductor 1 is ensured by introduction of the angle A, that has to be in the range 90° to 180°. This angle is defined between the first section and the second section of the fastening element.

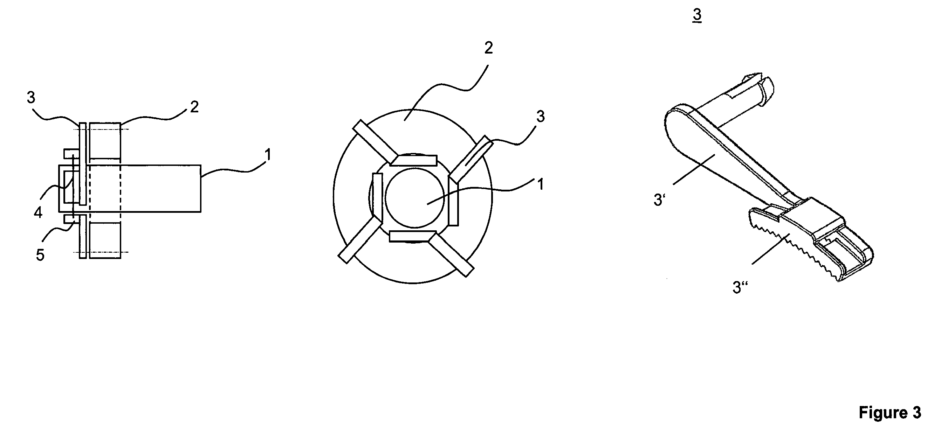

Figure 3 displays the concept of a pivotable first section 3' of the fastening element 3. So the first section 3' is pivotable to the second section, in a pivotation plane, which is rectangular to the long axis of conductor 2. Such a solution allows usage of the same sensing device 2, employing those rotating fastening elements 3, in the applications with different primary conductor 1 diameters and/or in the applications with different electrical device containing the primary conductor 3 sizes.

Material of the fastening components must be selected in such way to ensure the requested mechanical stability of the current and/or voltage measurement device, sufficient contact force between the fastening component surface and a surface of a device to which the current and/or voltage sensing device containing the fastening components is to be connected and easy mounting process and removal process of the current and/or voltage measurement device.

The advantages of the proposed solution are the reduction of the fastening material needed and the elimination of the special assembling tool necessity which enables both shortening of the manufacturing time and production cost cutting.
The next advantages are very easy and fast sensing device 2 mounting and removal and, as well, simple maintenance.
Additional significant advantage of the special fastening elements 3 application, as described above, is improved sensing accuracy of the measurement device 2 ensured by the stable and fixed sensing device 2 position within the measured current and/or voltage signal source (i.e. primary conductor 1).
The fastening of the sensor needs no special tools, and the positioning of the sensor could be realized with high reproductive accuracy.

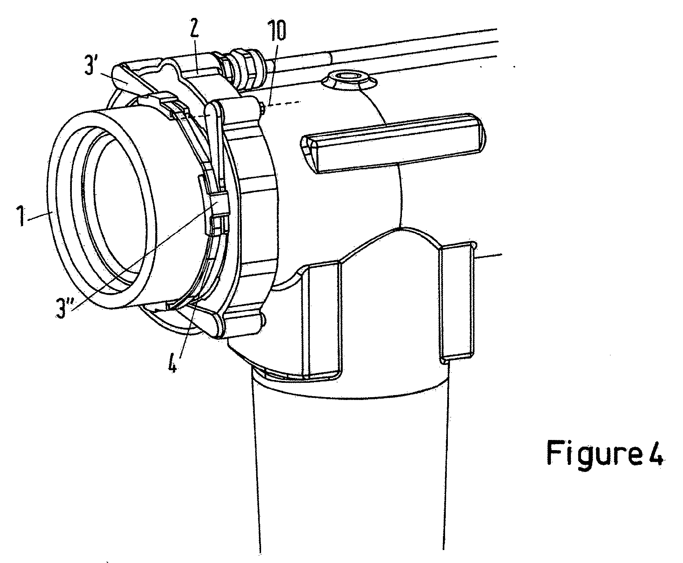

Figure 4 shows a perspective view of how the toroidal sensor device is placed around the conductor, with the help of the aforesaid fixation or fastening elements.
The dowel pins are inserted into openings, which are arranged at the circumfertial line of the toroidal housing of the aforesaid sensor device. The axis of the openings are parallel to the long axis of the conductor.
Therefore the fastening means are rotatable around the axis of the dowel pin. This results in th fact, that the second section 3" of the fastening elements can be adapted closest to the conductor skin surface. An arrangement of three or four of such fastening elements are mechanically fixed by a common tightening strip.

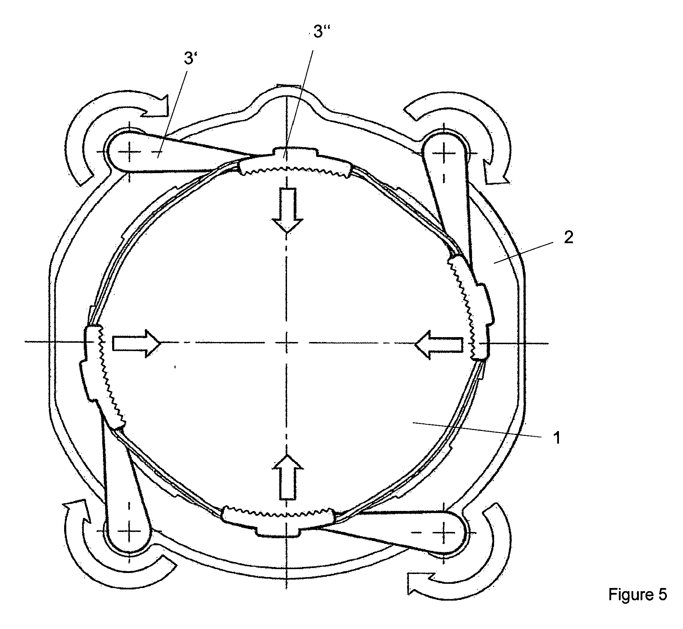

Figure 5 shows in detail by a front view, that the fastening means can be rotated in such, that the second section 3" can be adapted to the conductor diameter, so that the fastening means can be fitted to different conductors diameters.

### Position numbers

- 1: electrical conductor
- 2: sensor / sensor housing
- 3: fastening element
3' first section of the fastening element
3" second section of the fastening element
- 4: tightening strip
- 5: eye-element
10 dowel pin or clamp
11 strutured surface area, or structured coverage

## Claims

1. Fastening device for fastening a voltage and/or current sensor on an electrical conductor, wherein the fastening device comprises of a number of at least two fastening elements (3), each with a dowel pin clip, or a clamp at a first section (3') of the fastening element, and a support element at a second section (3") of the fastening element, **characterized in that** the dowel pin clip (10) or the clamp is insertable into or clampable on the toroidal housing of the voltage and/or current sensor (2) at the first section (3'), and the support element at the second section (3") is fixable on the electrical conductor (1), that at least two fastening elements are fixable with their dowel pin or dowel pin clip in openings placed at a circumferential region of the toroidal housing of the voltage and/or current sensor, and that the axis of the openings are in parallel to the conductor, and that the toroidal housing of the voltage and/or current sensor is placed around the conductor in such, that the fastening elements can be rotated around the dowel pin axis in such, that the second section (3") can be placed and adapted towards the electrical conductor shell or skin surface, in order to adapt to different electrical conductor diameters.

2. Fastening device according to claim 1,
**characterized in**
**that** the support element of an arrangement of the at least two fastening elements is fixable on the electrical conductor with a tightening strap (4) or a fixating ring.

3. Fastening device according to claim 1 or 2,
**characterized in**
**that** the support element is provided with an eye-element (5), through which the tightening strap (4) or the fixating ring is guided, in order to fix the position of the fastening element.

4. Fastening device according to claim 1 or 2, or 3,
**characterized in**
**that** the geometry of the voltage and/or current sensor is a circular ring element, to be positioned around the electrical conductor which is fastenable with the fastening device.

5. Fastening device according to one of the aforesaid claims,
**characterized in**
**that** the fixating ring or the tightening strap is removable, and/or changeable in the position.

6. Fastening device according to one of the aforesaid claims 1 to 5,
**characterized in**
**that** a first section and a second section of the fastening element are connected together in a fixed angle position between 90° and 180°.

7. Fastening device according to one of the aforesaid claims 1 to 5,
**characterized in**
**that** the first section (3') and the second section (3") of the fastening element are connected in that way, that the angle position between the first and the second section is variable between 90° and 180°.

8. Fastening device according to one of the aforesaid claims 1 to 5,
**characterized in**
**that** the first section (3') is pivotable relative to the second section (3") in that way, that the pivotation plane is rectangular to the long axis of the electrical conductor.

9. Fastening device according to one of the aforesaid claims,
**characterized in**
**that** the contact side of the second section (3") of the fastening element to the electrical conductor surface is provided with a rough or structured surface (11) or with such a surface coverage.

## Patentansprüche

1. Befestigungsvorrichtung zum Befestigen eines Spannungs- und/oder Stromsensors auf einem elektrischen Leiter, wobei die Befestigungsvorrichtung eine Anzahl von wenigstens zwei Befestigungselementen (3) umfasst, jeweils mit einem Spreizdübelclip oder einer Klammer in einem ersten Abschnitt (3') des Befestigungselements und mit einem Abstützelement in einem zweiten Abschnitt (3") des Befestigungselements,
**dadurch gekennzeichnet,**
**dass** der Spreizdübelclip (10) oder die Klammer in das toroidale Gehäuse des Spannungs- und/oder Stromsensors (2) in den ersten Abschnitt (3') einführbar oder an dieses klemmbar ist und das Abstützelement in dem zweiten Abschnitt (3") an dem elektrischen Leiter (1) fixierbar ist,
**dass** wenigstens zwei Befestigungselemente mit ihrem Spreizdübel oder Spreizdübelclip in Öffnungen, die in einem Umfangsgebiet des toroidalen Gehäuses des Spannungs- und/oder Stromsensors platziert sind, fixierbar sind und
**dass** die Achse der Öffnungen parallel zu dem Leiter ist, und
**dass** das toroidale Gehäuse des Spannungs- und/oder Stromsensors so um den Leiter herum platziert ist, dass die Befestigungselemente so um die Spreizdübelachse herum gedreht werden können, dass der zweite Abschnitt (3") zu der Hüllen- oder Verkleidungsoberfläche des elektrischen Leiters hin platziert und angepasst werden kann, so dass sie sich an verschiedene Durchmesser des elektrischen Leiters anpassen können.

2. Befestigungsvorrichtung nach Anspruch 1, **dadurch gekennzeichnet, dass** das Abstützelement einer Anordnung der wenigstens zwei Befestigungselemente mit einem Spannband (4) oder mit einem Fixierring auf dem elektrischen Leiter fixierbar ist.

3. Befestigungsvorrichtung nach Anspruch 1 oder 2, **dadurch gekennzeichnet, dass** das Abstützelement mit einem Öhsenelement (5) bereitgestellt ist, durch das das Spannband (4) oder der Fixierring geführt wird, um die Position des Befestigungselements zu fixieren.

4. Befestigungsvorrichtung nach Anspruch 1, 2 oder 3, **dadurch gekennzeichnet, dass** die Geometrie des Spannungs- und/oder Stromsensors ein kreisförmiges Ringelement ist, das um den elektrischen Leiter herum zu positionieren ist und das mit der Befestigungsvorrichtung befestigbar ist.

5. Befestigungsvorrichtung nach einem der vorhergehenden Ansprüche, **dadurch gekennzeichnet, dass** der Fixierring oder das Spannband abnehmbar ist und/oder in der Position änderbar ist.

6. Befestigungsvorrichtung nach einem der vorhergehenden Ansprüche 1 bis 5, **dadurch gekennzeichnet, dass** ein erster Abschnitt und ein zweiter Abschnitt des Befestigungselements in einer festen Position mit einem Winkel zwischen 90° und 180° miteinander verbunden sind.

7. Befestigungsvorrichtung nach einem der vorhergehenden Ansprüche 1-5, **dadurch gekennzeichnet, dass** der erste Abschnitt (3') und der zweite Abschnitt (3") des Befestigungselements auf solche Weise verbunden sind, dass die Position mit einem Winkel zwischen dem ersten und dem zweiten Abschnitt zwischen 90° und 180° variabel ist.

8. Befestigungsvorrichtung nach einem der vorhergehenden Ansprüche 1 bis 5, **dadurch gekennzeichnet, dass** der erste Abschnitt (3') relativ zu dem zweiten Abschnitt (3") auf solche Weise schwenkbar ist, dass die Schwenkebene im rechten Winkel zu der Längsachse des elektrischen Leiters ist.

9. Befestigungsvorrichtung nach einem der vorhergehenden Ansprüche, **dadurch gekennzeichnet, dass** die Kontaktseite des zweiten Abschnitts (3") des Befestigungselements zu der Oberfläche des elektrischen Leiters hin mit einer rauen oder strukturierten Oberfläche (11) oder mit einer solchen Oberflächenabdeckung bereitgestellt ist.

## Revendications

1. Dispositif de fixation destiné à fixer un capteur de tension et/ou de courant sur un conducteur électrique, le dispositif de fixation étant composé d'éléments (3) de fixation au nombre d'au moins deux, chacun doté d'une agrafe à goupille, ou d'une pince au niveau d'une première section (3') de l'élément de fixation, et d'un élément de soutien au niveau d'une deuxième section (3") de l'élément de fixation, **caractérisé en ce que** l'agrafe (10) à goupille ou la pince peut être insérée dans ou serrée sur l'enceinte toroïdale du capteur de tension et/ou de courant (2) au niveau de la première section (3'), et **en ce que** l'élément de soutien au niveau de la deuxième section (3") peut être fixé sur le conducteur électrique (1), **en ce qu'**au moins deux éléments de fixation peuvent être fixés avec leur goupille ou leur agrafe à goupille dans des ouvertures placées dans une région circonférentielle de l'enceinte toroïdale du capteur de tension et/ou de courant, et **en ce que** l'axe des ouvertures est parallèle au conducteur, et **en ce que** l'enceinte toroïdale du capteur de tension et/ou de courant est placée autour du conducteur de telle sorte que les éléments de fixation puissent être tournés autour de l'axe de la goupille de telle sorte que la deuxième section (3") puisse être placée et adaptée en direction de la surface de coque ou d'enveloppe du conducteur électrique, afin de s'adapter à différents diamètres de conducteur électrique.

2. Dispositif de fixation selon la revendication 1, **caractérisé en ce que** l'élément de soutien d'un agencement desdits au moins deux éléments de fixation peut être fixé sur le conducteur électrique avec une sangle (4) à serrage ou une bague d'immobilisation.

3. Dispositif de fixation selon la revendication 1 ou 2, **caractérisé en ce que** l'élément de soutien est muni d'un élément (5) d'oeillet, à travers lequel la sangle (4) à serrage ou la bague d'immobilisation est guidée afin de fixer la position de l'élément de fixation.

4. Dispositif de fixation selon la revendication 1, 2 ou 3, **caractérisé en ce que** la géométrie du capteur de tension et/ou de courant est un élément en anneau circulaire, à positionner autour du conducteur électrique qui peut être fixé avec le dispositif de fixation.

5. Dispositif de fixation selon l'une des revendications susmentionnées, **caractérisé en ce que** la bague d'immobilisation ou la sangle à serrage est amovible et/ou **en ce que** sa position peut être modifiée.

6. Dispositif de fixation selon l'une des revendications 1 à 5 susmentionnées, **caractérisé en ce qu'**une première section et une deuxième section de l'élément de fixation sont liées entre elles dans une position angulaire fixée entre 90° et 180°.

7. Dispositif de fixation selon l'une des revendications 1 à 5 susmentionnées, **caractérisé en ce que** la première section (3') et la deuxième section (3") de l'élément de fixation sont liées de telle manière que la position angulaire entre la première et la deuxième section soit variable entre 90° et 180°.

8. Dispositif de fixation selon l'une des revendications 1 à 5 susmentionnées, **caractérisé en ce que** la première section (3') peut pivoter par rapport à la deuxième section (3") de telle manière que le plan de pivotement soit perpendiculaire à l'axe longitudinal du conducteur électrique.

9. Dispositif de fixation selon l'une des revendications susmentionnées, **caractérisé en ce que** le côté de contact de la deuxième section (3") de l'élément de fixation avec le conducteur électrique surface est muni d'une surface rugueuse ou structurée (11) ou d'un revêtement de surface similaire.
